(19) Europäisches Patentamt
European Patent Office
Office européen des brevets

(11) **EP 4 577 022 A1**

(12) **EUROPEAN PATENT APPLICATION**

(43) Date of publication:
**25.06.2025  Bulletin 2025/26**

(21) Application number: **24209785.5**

(22) Date of filing: **30.10.2024**

(51) International Patent Classification (IPC):
***H10K 59/80*** (2023.01)

(52) Cooperative Patent Classification (CPC):
**H10K 59/8794**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **18.12.2023  KR 20230184122**

(71) Applicant: **Samsung Display Co., Ltd.**
**Yongin-si, Gyeonggi-Do 17113 (KR)**

(72) Inventors:
• **Jeong, Wee Joon**
**Yongin-si, Gyeonggi-do (KR)**

• **Koo, Ja Hun**
**Yongin-si, Gyeonggi-do (KR)**
• **Choi, Jang Un**
**Yongin-si, Gyeonggi-do (KR)**
• **Kum, Byung Gon**
**Yongin-si, Gyeonggi-do (KR)**
• **Shin, Taek Sun**
**Yongin-si, Gyeonggi-do (KR)**

(74) Representative: **Gulde & Partner**
**Patent- und Rechtsanwaltskanzlei mbB**
**Berliner Freiheit 2**
**10785 Berlin (DE)**

(54) **ORGANIC LIGHT EMITTING DIODE DISPLAY DEVICE**

(57)    An organic light emitting diode display device includes a display panel comprising an organic light emitting diode. A heat dissipation member faces the display panel. The heat dissipation member comprises a plurality of heat dissipation layers having different thicknesses and different thermal conductivities from each other.

## FIG. 5

**Description**

1. Technical Field

The present disclosure relates to a display device, and more particularly, to an organic light emitting diode display device whose heat dissipation speed can be increased.

2. Discussion of Related Art

Organic light emitting diode displays have self-luminous properties and do not require a separate light source as compared to liquid crystal displays. Therefore, organic light emitting diode display have reduced thickness and weight. In addition, organic light emitting diode displays are becoming increasingly popular as next-generation displays for televisions, monitors, and portable electronic devices due to their high-quality characteristics such as low power consumption, high luminance, and high response speed.

SUMMARY

Aspects of the present disclosure provide an organic light emitting diode display device whose heat dissipation speed can be increased.

According to an embodiment of the present disclosure, an organic light emitting diode display device includes a display panel comprising an organic light emitting diode. A heat dissipation member faces the display panel. The heat dissipation member comprises a plurality of heat dissipation layers having different thicknesses and different thermal conductivities from each other. The display device may further include a front cover, wherein the display panel may be disposed between the heat dissipation member and the front cover.

In an embodiment, the plurality of heat dissipation layers comprises a first heat dissipation layer; and a second heat dissipation layer between the first heat dissipation layer and the display panel.

In an embodiment, the second heat dissipation layer has a higher thermal conductivity than a thermal conductivity of the first heat dissipation layer and has a thickness that is less than a thickness of the first heat dissipation layer.

In an embodiment, a ratio between the thickness of the first heat dissipation layer and the thickness of the second heat dissipation layer is about 19: 1.

In an embodiment, the first heat dissipation layer has a thickness of about 820 $\mu$m and a thermal conductivity of about 240 W/mk, and the second heat dissipation layer has a thickness of about 100 $\mu$m and a thermal conductivity of about 1000 W/mk.

In an embodiment, the first heat dissipation layer comprises natural graphite, and the second heat dissipation layer comprises artificial graphite, i.e., synthetic graphite

The first heat dissipation layer may have thermal diffusion characteristics that spreads more of the heat generated by the display panel in a thickness direction of the heat dissipation member than in the first and second directions as compared with the second heat dissipation layer.

In an embodiment, the plurality of heat dissipation layers comprises: a first heat dissipation layer; a second heat dissipation layer between the first heat dissipation layer and the display panel; and a third heat dissipation layer between the first heat dissipation layer and the second heat dissipation layer.

In an embodiment, the third heat dissipation layer has a thickness greater than a thickness of the second heat dissipation layer and less than a thickness of the first heat dissipation layer, and the first heat dissipation layer has a thermal conductivity higher than thermal conductivity of the third heat dissipation layer and lower than thermal conductivity of the second heat dissipation layer.

In an embodiment, a ratio between the thickness of the first heat dissipation layer, the thickness of the third heat dissipation layer, and the thickness of the second heat dissipation layer is about 16:3:1.

In an embodiment, the first heat dissipation layer has a thickness of 500 $\mu$m or about 820 $\mu$m and a thermal conductivity of about 240 W/mk, the second heat dissipation layer has a thickness of about 100 $\mu$m and a thermal conductivity of about 1000 W/mk, and the third heat dissipation layer has a thickness of about 300 $\mu$m and a thermal conductivity of about 202 W/mk.

In an embodiment, the first heat dissipation layer comprises natural graphite, the third heat dissipation layer comprises metal, and the second heat dissipation layer comprises artificial graphite.

In an embodiment, the third heat dissipation layer comprises aluminum.

In an embodiment, further comprising a housing surrounding the plurality of heat dissipation layers.

In an embodiment, the housing has at least one exhaust hole penetrating the housing.

In an embodiment, the housing includes a first surface and a second surface facing each other. The second surface is disposed closer to the display panel than the first surface, and the at least one exhaust hole penetrates the second surface of the housing.

In an embodiment, further comprising a housing selectively surrounding at least one of the plurality of heat dissipation layers.

In an embodiment, the plurality of heat dissipation layers comprise a first heat dissipation layer and a second heat dissipation layer between the first heat dissipation layer and the display panel, and the housing surrounds the first heat dissipation layer.

In an embodiment, the plurality of heat dissipation layers comprise a first heat dissipation layer, a second heat dissipation layer between the first heat dissipation layer and the display panel and a third heat dissipation layer between the first heat dissipation layer and the second heat dissipation layer, and the housing surrounds the first heat dissipation layer.

In an embodiment, a total thickness of the heat dissipation layers is in a range of about 50% to about 150% of a thickness of the display panel.

In an embodiment, the total thickness of the heat dissipation layers is in a range of about 0.5 to about 1.5 mm.

According to an aspect of the present disclosure, a display device includes a display panel. A heat dissipation member is disposed on the display panel and dissipates heat generated by the display panel away from the display panel. The heat dissipation member includes a first heat dissipation layer disposed on the display panel and extending in a first direction and a second direction crossing the first direction. A second heat dissipation layer disposed between the first heat dissipation layer and the display panel and extending in the first and second directions. The first heat dissipation layer has thermal diffusion characteristics that spreads more of the heat generated by the display panel in a thickness direction of the heat dissipation member than in the first and second directions as compared with the second heat dissipation layer.

In an organic light emitting diode display device according to the present disclosure, heat dissipation speed can be increased. In addition, since afterimages are minimized or prevented, image quality can be increased.

The effects of embodiments of the present disclosure are not limited to the above-described effects and other effects which are not described herein will become apparent to those skilled in the art from the following description.

BRIEF DESCRIPTION OF THE DRAWINGS

These and/or other aspects will become apparent and more readily appreciated from the following description of non-limiting embodiments, taken in conjunction with the accompanying drawings in which:

FIG. 1 is an exploded perspective view of a display device according to an embodiment;
FIG. 2 is a plan view of the display device according to an embodiment;
FIG. 3 is a circuit diagram of the display device according to an embodiment;
FIG. 4 is a side view of the display device according to an embodiment;
FIG. 5 is a rear view of the display device according to an embodiment;
FIG. 6 is a cross-sectional view of a display device according to an embodiment;
FIG. 7 is a cross-sectional view of a display device according to an embodiment;
FIG. 8 is a cross-sectional view of a display device according to an embodiment;
FIG. 9 is a cross-sectional view of a display device according to an embodiment;
FIG. 10 is a cross-sectional view of a display device according to an embodiment;
FIG. 11 is a cross-sectional view of a display device according to an embodiment;
FIG. 12 is a cross-sectional view of a display device according to an embodiment;
FIGS. 13 through 17 are cross-sectional views illustrating the structures of light emitting elements according to embodiments;
FIG. 18 is a cross-sectional view illustrating an example of an organic light emitting diode of FIG. 16 according to an embodiment;
FIG. 19 is a cross-sectional view illustrating an example of an organic light emitting diode of FIG. 17 according to an embodiment;
FIG. 20 is a cross-sectional view illustrating the pixel structure of a display device according to an embodiment;
FIG. 21 is a diagram for explaining the effect of a display device according to an embodiment; and
FIG. 22 is a diagram for explaining the effect of a display device according to an embodiment.

DETAILED DESCRIPTION OF EMBODIMENTS

Advantages and features of the present disclosure and methods to achieve them will become apparent from the descriptions of non-limiting embodiments hereinbelow with reference to the accompanying drawings. However, the present disclosure is not limited to embodiments disclosed herein but may be implemented in various different ways. The embodiments are provided for making the disclosure of the present disclosure thorough and for fully conveying the scope of the present disclosure to those skilled in the art. It is to be noted that the scope of the present disclosure is defined only by the claims.

As used herein, a phrase "an element A on an element B" refers to that the element A may be disposed directly on the element B and/or the element A may be disposed indirectly on the element B via another element C. Like reference numerals denote like elements throughout the descriptions. The figures, dimensions, ratios, angles, numbers of elements given in the drawings are merely illustrative and are not limiting.

Although terms such as first, second, etc. are used to distinguish arbitrarily between the elements such terms describe, and thus these terms are not necessarily intended to indicate temporal or other prioritization of such elements. These terms are used to merely distinguish one element from another. Accordingly, as used herein, a first element may be a second element within the technical scope of the present disclosure.

Features of various embodiments of the present disclosure may be combined partially or totally. As will be clearly appreciated by those skilled in the art, technically various interactions and operations are possible. Various embodiments can be practiced individually or in combination.

Hereinafter, embodiments of the present disclosure will be described with reference to the accompanying drawings.

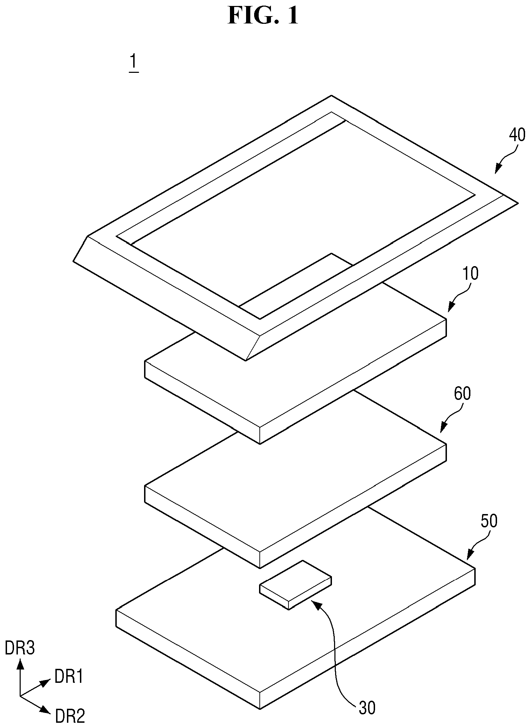

FIG. 1 is an exploded perspective view of a display device 1 according to an embodiment.

Referring to FIG. 1, the display device 1 according to an embodiment may be applied to smartphones, mobile phones, tablet personal computers (PCs), personal digital assistants (PDAs), portable multimedia players (PMPs), televisions, game consoles, wristwatch-type electronic devices, head mounted displays, monitors of PCs, laptop computers, car navigation systems, car dashboards, digital cameras, camcorders, outdoor billboards, electronic display boards, medical devices, examination devices, various home appliances such as refrigerators and washing machines, or Internet of things (IoT) devices. However, embodiments of the present disclosure are not necessarily limited thereto.

In the present specification, a large display device (e.g., a large organic light emitting diode display device) such as a television will be described as an example of the display device 1 for convenience of explanation. In an embodiment, the television may have high resolution or ultrahigh resolution such as HD, UHD, 4K, or 8K.

In addition, the display device 1 according to an embodiment may be variously classified according to a display method. For example, in some embodiments the display device 1 may be classified as an organic light emitting diode display device, an inorganic electroluminescent (EL) display device, a quantum dot light emitting display device (QED), a micro-light emitting diode display device, a nano-light emitting diode display device, a plasma display panel (PDP), a field emission display (FED) device, a cathode ray tube (CRT) display device, a liquid crystal display (LCD) device, or an electrophoretic display (EPD) device. An organic light emitting diode display device will be described below as an example of the display device 1 for convenience of explanation. Unless a special distinction is required, the organic light emitting diode display device applied to described embodiments will be simply shortened to a display device. However, embodiments of the present disclosure are not necessarily limited to the organic light emitting diode display device, and other display devices listed above or known in the art can also be applied.

In an embodiment, the display device 1 may include a heat dissipation member 60, a display panel 10, and a front cover 40. In an embodiment, the heat dissipation member 60, the display panel 10, and the front cover 40 may be disposed, for example, along a third direction DR3. The display panel 10 may be disposed between the heat dissipation member 60 and the front cover 40 (e.g., in the third direction DR3).

In an embodiment, the display panel 10 may be a self-luminous display panel 10. The display panel 10 as a self-luminous display panel 10 may be an organic light emitting display panel 10 including an organic light emitting diode. However, embodiments of the present disclosure are not necessarily limited thereto, and other types of display panels 10 such as a liquid crystal display panel, a quantum dot organic light emitting display panel 10, a quantum dot liquid crystal display panel, a quantum nano-light emitting display panel 10, and a micro-light emitting diode display panel may also be applied.

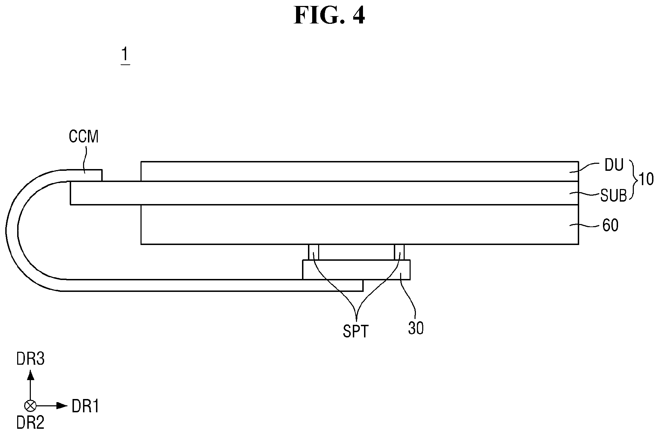

In an embodiment, the display panel 10 may include a substrate SUB (see FIG. 4) and a display layer DU (see FIG. 4) disposed on the substrate SUB. The detailed structure of the display panel 10 will be described later with reference to FIG. 4 and the like.

The heat dissipation member 60 may face the display panel 10. In an embodiment, the heat dissipation member 60 may dissipate heat generated from the display panel 10 and a driving board 30 (see FIG. 4) away from the display panel 10 to another space inside the display device 1 or to the outside (e.g., the external environment). For example, in an embodiment the heat dissipation member 60 may dissipate the heat generated from the display panel 10 and the driving board 30 to the internal space of the front cover 40 or to the outside of the display device 1 (e.g., the external environment).

According to an embodiment, the heat dissipation member 60 may include metal such as aluminum.

The display device 1 including a heat dissipation member such as the heat dissipation member 60 can quickly disperse or dissipate heat generated from the driving board 30.

In an embodiment, the front cover 40 and the heat dissipation member 60 may surround the display panel 10 and the driving board 30. The front cover 40 may protect the display panel 10 and the driving board 30 from external shock.

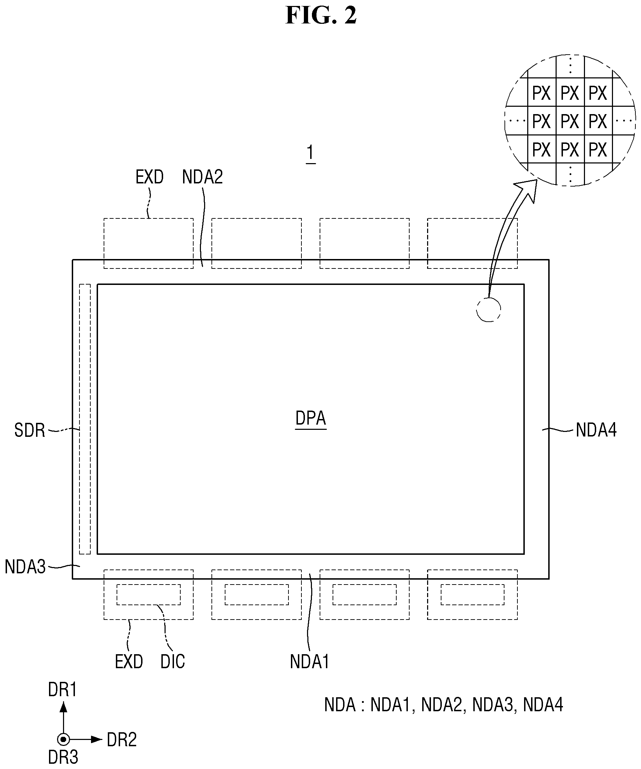

In an embodiment, the front cover 40 may include a highly transparent material to allow light emitted from the display panel 10 to pass therethrough. For example, in an embodiment the front cover 40 may include polymer resin such as polyimide or glass. However, embodiments of the present disclosure are not necessarily limited thereto. In an embodiment, the front cover 40 may include an opening in an area overlapping a display area DPA (see FIG. 2).

In an embodiment, each of the heat dissipation member 60, the display panel 10, and the front cover 40 may include relatively long sides extending in a first direction DR1 and relatively short sides extending in a second direction DR2. However, embodiments of the present disclosure are not necessarily limited thereto and the shape of the heat dissipation member 60, the display panel 10, and the front cover 40 may vary.

In some embodiments, the display device 1 may not include the front cover 40.

FIG. 2 is a plan view of the display device 1 according to an embodiment.

Referring to FIG. 2, the display device 1 according to an embodiment may have a quadrate shape in a plan view. For example, the display device 1 may have a rectangular shape (e.g., in a plane defined in the first and second directions DR1, DR2). However, embodiments of the present disclosure are not necessarily limited thereto.

In some embodiments, when the display device 1 is a television, the relatively long sides may be located in a horizontal direction. However, embodiments of the present disclosure are not necessarily limited thereto, and the relatively long sides may also be located in a vertical direction, or the display device 1 may be rotatably installed so that the relatively long sides can be variably located in the horizontal or vertical direction.

The display device 1 may include the display area DPA and a non-display area NDA. The display area DPA may be an active area in which an image is displayed. In an embodiment, the display area DPA may have a rectangular shape similar to the overall shape of the display device 1 in a plan view (e.g., in a plane defined in the first and second directions DR1, DR2). However, embodiments of the present disclosure are not necessarily limited thereto.

The display area DPA may include a plurality of pixels PX. The pixels PX may be arranged in a matrix direction. In an embodiment, each of the pixels PX may be rectangular or square in a plan view (e.g., in a plane defined in the first and second directions DR1, DR2). However, embodiments of the present disclosure are not necessarily limited thereto. For example, in an embodiment each of the pixels PX may have a rhombus shape having each side inclined with respect to a side of the display device 1. The pixels PX may include pixels PX which provide light of different colors (e.g., wavelengths). For example, in an embodiment the pixels PX may include red pixels providing red light, green pixels PX providing green light, and blue pixels providing blue light. However, embodiments of the present disclosure are not necessarily limited thereto and the pixels PX may have various different colors. In an embodiment, the color pixels PX may be alternately arranged in a stripe or pentile type.

In an embodiment, the non-display area NDA may be disposed around the display area DPA (e.g., in the first and/or second directions DR1, DR2). The non-display area NDA may form the bezel of the display device 1. The non-display area NDA may entirely or partially surround the display area DPA (e.g., in the first and/or second directions DR1, DR2).

In some embodiments, the display area DPA may have a rectangular shape, and the non-display area NDA may be disposed adjacent to four sides of the display area DPA. For example, in an embodiment the non-display area NDA may include a first non-display area NDA1 disposed adjacent to a first relatively long side (e.g., a lower side in the first direction DR1 in FIG. 2) of the display device 1, a second non-display area NDA2 disposed adjacent to a second relatively long side (e.g., an upper side in the first direction DR1 in FIG. 2), a third non-display area NDA3 disposed adjacent to a first relatively short side (e.g., a left side in the second direction DR2 in FIG. 2), and a fourth non-display area NDA4 disposed adjacent to a second relatively short side (e.g., a right side in the second direction DR2 in FIG. 2).

In an embodiment, driving circuits or driving elements for driving the display area DPA may be disposed in the non-display area NDA. For example, a pad portion may be positioned on the substrate SUB of the display panel 10 in the first non-display area NDA1 and the second non-display area NDA2, and external devices EXD may be mounted on pad electrodes of the pad portion. In an embodiment, each of the external devices EXD may include a circuit member CCM (see FIG. 4) which will be described later. Examples of the external devices EXD may include connection films, printed circuit boards, driving chips DIC, connectors, and wiring connection films. However, embodiments of the present disclosure are not necessarily limited thereto. For another example, a scan driver SDR disposed directly on the substrate SUB of the display panel 10 may be disposed in the third non-display area NDA3.

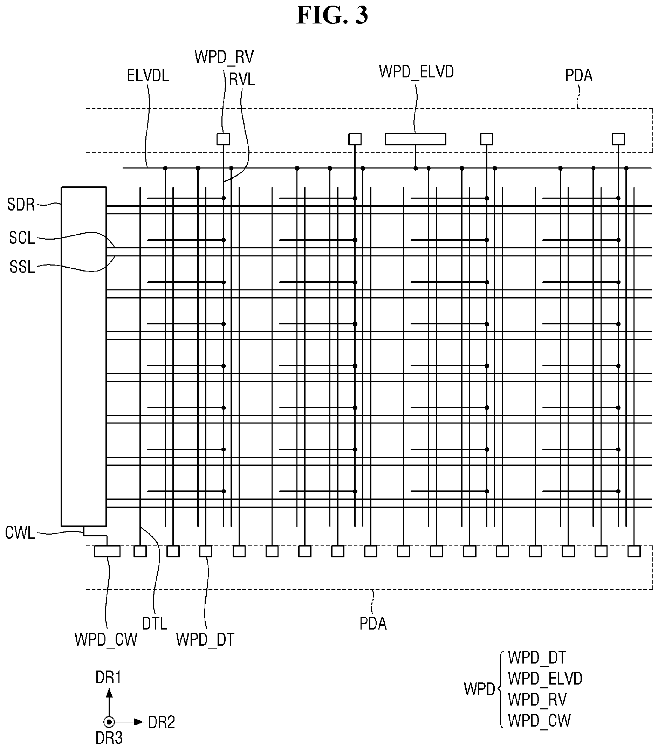

FIG. 3 is a circuit diagram of the display device 1 according to an embodiment.

Referring to FIG. 3, a plurality of lines may be disposed on the substrate SUB of the display device 1. In an embodiment, the lines may include scan lines SCL, sensing signal lines SSL, data lines DTL, reference voltage lines RVL, and a first power line ELVDL.

In an embodiment, the scan lines SCL and the sensing signal lines SSL may extend in the second direction DR2. The scan lines SCL and the sensing signal lines SSL may be connected to the scan driver SDR. In an embodiment, the scan driver SDR may include a driving circuit composed of circuit layers. In an embodiment, the scan driver SDR may be disposed in the third non-display area NDA3. However, embodiments of the present disclosure are not necessarily limited thereto, and the scan driver SDR may also be disposed in the fourth non-display area NDA4 or may also be disposed in both the third non-display area NDA3 and the fourth non-display area NDA4. In an embodiment, the scan driver SDR may be connected to a signal connection line CWL, and at least one end of the signal connection line CWL may form a pad WPD_CW in the first non-display area NDA1 and/or the second non-display area NDA2 and thus may be connected to an external device EXD (see FIG. 2).

In the drawing, the first direction DR1 and the second direction DR2 are horizontal directions and intersect each other. For example, the first direction DR1 and the second direction DR2 may be orthogonal to each other. In addition, the third direction DR3 may be a vertical direction intersecting the first direction DR1 and the second direction DR2, for example, orthogonal to the first direction DR1 and the second direction DR2. However, embodiments of the present disclosure are not necessarily limited thereto and the first to third directions DR1, DR2, DR3 may cross each other at various different angles. In the present specification, a direction indicated by an arrow of each of the first through third directions DR1 through DR3 may be referred to as one side, and the opposite direction may be referred to as the other side.

In an embodiment, the data lines DTL and the reference voltage lines RVL may extend in the first direction DR1 intersecting the second direction DR2. The first power line ELVDL may include a portion extending in the first direction DR1. The first power line ELVDL may further include portions extending in the second direction DR2. In an embodiment, the first power line ELVDL may have a mesh structure. However, embodiments of the present disclosure are not necessarily limited thereto.

A wiring pad WPD may be disposed on at least one end of each of the data lines DTL, the reference voltage lines RVL, and the first power line ELVDL. Each wiring pad WPD may be disposed in a pad portion PDA of the non-display area NDA. In an embodiment, wiring pads WPD_DT (hereinafter, referred to as "data pads") of the data lines DTL may be disposed in the pad portion PDA of the first non-display area NDA1, and wiring pads WPD_RV (hereinafter, referred to as 'reference voltage pads') of the reference voltage lines RVL and a wiring pad WPD_ELVD (hereinafter, referred to as a 'first power pad') of the first power line ELVDL may be disposed in the pad portion PDA of the second non-display area NDA2. Alternatively, the data pads WPD_DT, the reference voltage pads WPD_RV, and the first power pad WPD_ELVD may all be disposed in the same area, for example, in the first non-display area NDA1. The external devices EXD (see FIG. 2) may be mounted on the wiring pads WPD as described above. In an embodiment, the external devices EXD may be mounted on the wiring pads WPD through anisotropic conductive films, ultrasonic bonding, or the like.

In an embodiment, each pixel PX on the substrate SUB of the display panel 10 may include a pixel driving circuit. The above-described lines may transmit driving signals to each pixel driving circuit while passing through or around each pixel PX. The pixel driving circuit may include a transistor and a capacitor. The number of transistors and capacitors in each pixel driving circuit can be variously changed and are not necessarily limited to those shown in the figures.

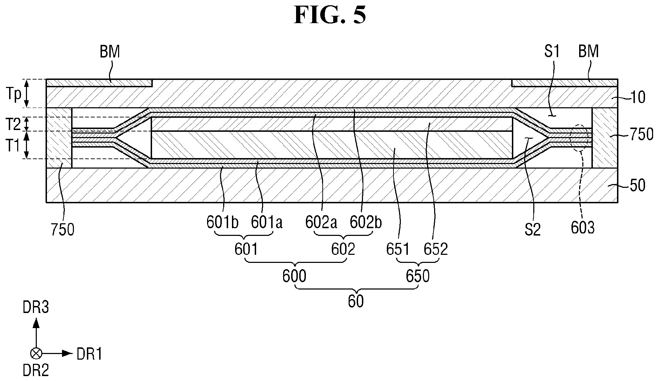

FIG. 4 is a side view of the display device 1 according to an embodiment. FIG. 5 is a cross-sectional view of the display device 1 according to an embodiment.

Referring to FIGS. 4 and 5, the display panel 10 may include the substrate SUB and the display layer DU.

The substrate SUB may be a base substrate or a base member. In an embodiment, the substrate SUB may be a flexible substrate that can be bent, folded, rolled, etc. For example, in an embodiment the substrate SUB may include polymer resin such as polyimide (PI). However, embodiments of the present disclosure are not necessarily limited thereto. In an embodiment, the substrate SUB may include a glass material or a metal material.

In an embodiment, the display layer DU may include a thin-film transistor layer, a light emitting element layer, and a thin-film encapsulation layer.

In an embodiment, the thin-film transistor layer may include a plurality of thin-film transistors constituting pixel circuits of pixels and various lines described in FIG. 3. The light emitting element layer may include a plurality of light emitting elements, each including a first electrode, a light emitting layer, and a second electrode to emit light. The thin-film encapsulation layer may cover upper and side surfaces of the light emitting element layer and may protect the light emitting element layer. In an embodiment, the thin-film encapsulation layer may include at least one inorganic layer and at least one organic layer.

In an embodiment, the circuit member CCM may be a connection film, a driving integrated circuit (IC) chip, a connector, a printed circuit board PCB, or a flexible printed circuit board FPCB. In an embodiment in which the circuit member CCM is a flexible member, the circuit member CCM may be bent so that at least a portion of the circuit member CCM faces a rear surface of the substrate SUB.

The circuit member CCM may be mounted on the substrate SUB through the pad portion. In an embodiment, one end of the circuit member CCM may be connected to the substrate SUB, and the other end of the circuit member CCM may be connected to the driving board 30. In an embodiment in which a plurality of circuit members CCM are connected, both ends of each circuit member CCM may be connected to other circuit members CCM.

The driving board 30 may be positioned behind the substrate SUB (e.g., in the third direction DR3) by the bending of the circuit member CCM. In an embodiment, the driving board 30 may be spaced apart from the display panel 10. In a non-limiting embodiment, the driving board 30 may be parallel to the display panel 10.

In an embodiment, as shown in FIG. 4, the driving board 30 may be located on an opposite side from the display panel 10 with the heat dissipation member 60 interposed between them (e.g., in the third direction DR3). In an embodiment, the driving board 30 may be arranged to overlap the center of the heat dissipation member 60 in a plan view. In an embodiment, the driving board 30 may be supported and fixed by a support SPT disposed between the heat dissipation member 60 and the driving board 30.

In an embodiment, the driving board 30 may include a processor, memory, and/or an interface. In an embodiment, the driving board 30 may include various electronic components, such as IC chips, etc.

In the drawing, a chip on film (COF) structure in which the substrate SUB, the circuit member CCM and the driving board 30 are connected in this order is illustrated. However, embodiments of the present disclosure are not necessarily limited thereto. For example, in an embodiment, a chip on plastic (COP) structure in which the driving board 30 is directly mounted on the substrate SUB without the circuit member CCM, and the substrate SUB itself is bent may be provided. However, other embodiments in which the driving board 30 is disposed on a rear surface of the display panel 10 and the heat dissipation member 60 is disposed between the display panel 10 and the driving board 30 (e.g., in the third direction DR3) may be implemented.

The heat dissipation member 60 may be disposed between the display panel 10 and the driving board 30 (e.g., in the third direction DR3). For example, the heat dissipation member 60 may be disposed behind the display panel 10 and in front of the driving board 30.

In the present specification and drawings, 'front' refers to a direction indicated by the third direction DR3, and 'behind' refers to a direction indicated by a reverse direction (hereinafter, referred to as a third reverse direction) of the third direction DR3.

In some embodiments, the heat dissipation member 60 may directly contact the rear surface of the display panel 10. Accordingly, heat generated from the display panel 10 may be transferred to the heat dissipation member 60.

As illustrated in the drawing, in an embodiment the heat dissipation member 60 may be spaced apart from the driving board 30 with the support SPT interposed between them. However, embodiments of the present disclosure are not necessarily limited thereto. In some embodiments, to reduce the thickness of the display device 1 and increase heat dissipation efficiency, the support SPT may be omitted, and the heat dissipation member 60 may directly contact the driving board 30. Even in embodiments in which the support SPT is provided, a distance between the heat dissipation member 60 and the driving board 30 may be minimized. Accordingly, heat generated from the driving board 30 can be transferred to the heat dissipation member 60.

The heat dissipation member 60 may dissipate heat generated from the display panel 10 and the driving board 30 to another space inside the display device 1 or to the outside (e.g., an external environment).

FIG. 5 is a cross-sectional view of the display device 1 according to an embodiment.

As illustrated in FIG. 5, the display device 1 according to an embodiment may include a rear cover 50, the display panel 10, the heat dissipation member 60, and an adhesive layer 750.

In an embodiment, the display panel 10 may include a light blocking layer BM disposed in the non-display area NDA. For example, the light blocking layer BM may be disposed on edges of the display panel 10. In an embodiment, in a plan view, the light blocking layer BM may be shaped like a closed curve surrounding a heat dissipation layer 650. For example, in a plan view, the light blocking layer BM may be shaped like a quadrangular ring.

In an embodiment, the adhesive layer 750 may be disposed between edges of the rear cover 50 and the edges of the display panel 10 (e.g., in the third direction DR3). In a plan view, the adhesive layer 750 may be shaped like a closed curve surrounding the heat dissipation member 60 between the edges of the rear cover 50 and the edges of the display panel 10. For example, in a plan view, the adhesive layer 750 may be shaped like a quadrangular ring surrounding the heat dissipation member 60. A surface of the adhesive layer 750 may be attached to the rear cover 50, and the other surface of the adhesive layer 750 may be attached to the display panel 10 (e.g., the substrate SUB of the display panel 10).

The heat dissipation member 60 may be disposed between the rear cover 50 and the display panel 10 (e.g., in a third direction DR3). In a plan view, the heat dissipation member 60 may have a quadrangular shape. The heat dissipation member 60 may include a housing 600 and the heat dissipation layer 650. For example, the heat dissipation member 60 may be disposed in a first space S1 surrounded and defined by the rear cover 50, the display panel 10, and the adhesive layer 750.

The housing 600 may define a second space S2 (e.g., an internal space) in which the heat dissipation layer 650 is disposed. The housing 600 may include a first housing plate 601 and a second housing plate 602 facing each other in the third direction DR3. The first housing plate 601 and the second housing plate 602 may be spaced apart from each other in the third direction DR3. The first housing plate 601 and the second housing plate 602 may be coupled to each other at edges (e.g., edges in the first direction DR1). For example, the edges of the first housing plate 601 may be bent towards the edges of the second housing plate 602, and the edges of the second housing plate 602 may be bent toward the edges of the first housing plate 601. Since the edges of the first housing plate 601 and the edges of the second housing plate 602 are in direct contact with (and/or bonded to) each other, the second space S2 of the housing 600 may be sealed. A portion where the edges of the first housing plate 601 and the edges of the second housing plate 602 are bonded may function as a flange 603 for sealing the housing 600. In an embodiment, the adhesive layer 750, the flange 603 of the housing 600, and a bent portion adjacent to the flange 603 may be covered by the light blocking layer BM. For example, the adhesive layer 750, the flange 603 of the housing 600, and the bent portion adjacent to the flange 603 may be overlapped by the light blocking layer BM (e.g., in the third direction DR3).

In an embodiment, the first housing plate 601 may include a first inner plate 601a and a first outer plate 601b. The first inner plate 601a and the first outer plate 601b may have substantially the same shape as each other. For example, in an embodiment the first inner plate 601a and the first outer plate 601b may have the same shape as the first housing plate 601 described above. The first inner plate 601a and the first outer plate 601b may be in direct contact with (and/or bonded to) each other. The first inner plate 601a and the first outer plate 601b may have the same thickness. For example, in an embodiment each of the first inner plate 601a and the first outer plate 601b may have a thickness (e.g., a length in the third direction DR3) of about 25 μm. In an embodiment, the first inner plate 601a may include polyurethane, and the first outer plate 601b may include polyethylene terephthalate.

In an embodiment, the second housing plate 602 may include a second inner plate 602a and a second outer plate 602b. The second inner plate 602a and the second outer plate 602b may have substantially the same shape as each other. For example, the second inner plate 602a and the second outer plate 602b may have the same shape as the second housing plate 602 described above. The second inner plate 602a and the second outer plate 602b may be in direct contact with (and/or bonded to) each other. The second inner plate 602a and the second outer plate 602b may have the same thickness. For example, in an embodiment each of the second inner plate 602a and the second outer plate 602b may have a thickness (e.g., a length in the third direction DR3) of about 25 μm. In an embodiment, the second inner plate 602a may include polyurethane, and the second outer plate 602b may include polyethylene terephthalate.

The first inner plate 601a and the second inner plate 602a may be in direct contact with (and/or bonded to) each other at edges (e.g., edges in the first direction DR1).

In an embodiment, the heat dissipation layer 650 may be disposed in the second space S2 defined by the housing 600. For example, the heat dissipation layer 650 may be disposed between the first housing plate 601 and the second housing plate 602. As a specific example, the heat dissipation layer 650 may be disposed between the first inner plate 601a and the second inner plate 602a (e.g., in the third direction DR3).

The heat dissipation layer 650 may include a plurality of heat dissipation layers 651 and 652. For example, in an embodiment the heat dissipation layer 650 may include a first heat dissipation layer 651 and a second heat dissipation layer 652 stacked along the third direction DR3 within the second space S2 defined by the housing 600. The first heat dissipation layer 651 and the second heat dissipation layer 652 may include different materials from each other. In addition, the first heat dissipation layer 651 and the second heat dissipation layer 652 may have different thicknesses from each other. Here, the thickness of the heat dissipation layer 650 may mean the size of the heat dissipation layer 650 in the third direction DR3. In addition, the first heat dissipation layer 651 and the second heat dissipation layer 652 may have thermal conductivity.

The first heat dissipation layer 651 may be disposed on the first housing plate 601. For example, the first heat dissipation layer 651 may be disposed between the first housing plate 601 and the second heat dissipation layer 652 (e.g., in the third direction DR3) within the housing 600. As a specific example, the first heat dissipation layer 651 may be disposed between (e.g., directly therebetween in the third direction DR3) the first inner plate 601a and the second heat dissipation layer 652. A surface of the first heat dissipation layer 651 may directly contact the first inner plate 601a of the housing 600, and the other surface of the first heat dissipation layer 651 may directly contact the second heat dissipation layer 652. In an embodiment, the first heat dissipation layer 651 may have anisotropic thermal diffusion characteristics that spread more heat in an area direction (e.g., in the first direction DR1 and the second direction DR2 defining the area of the first heat dissipation layer 651 in a plan view) than in the thickness direction (e.g., the third reverse direction). In an embodiment, the first heat dissipation layer 651 may have a thermal conductivity of about 240 W/mk. In an embodiment, the first heat dissipation layer 651 may include natural graphite. For example, in an embodiment the first heat dissipation layer 651 may be composed substantially of, or entirely of, natural graphite.

The second heat dissipation layer 652 may be disposed on (e.g., disposed directly thereon in the third direction DR3) the first heat dissipation layer 651. For example, the second heat dissipation layer 652 may be disposed between the first heat dissipation layer 651 and the second housing plate 602 (e.g. in the third direction DR3) within the housing 600. As a specific example, the second heat dissipation layer 652 may be disposed between the first heat dissipation layer 651 and the second inner plate 602a (e.g., in the third direction DR3). A surface of the second heat dissipation layer 652 may directly contact the first heat dissipation layer 651, and the other surface of the second heat dissipation layer 652 may directly contact the second inner plate 602a of the housing 600. In an embodiment, the second heat dissipation layer 652 may have anisotropic thermal diffusion characteristics that spread more heat in the area direction (e.g., in the first direction DR1 and the second direction DR2 defining the area of the second heat dissipation layer 652 in a plan view) than in the thickness direction (e.g., the third reverse direction). In an embodiment, the second heat dissipation layer 652 may have a thermal conductivity of about 1000 W/mk. In an embodiment, the second heat dissipation layer 652 may include artificial graphite. For example, in an embodiment the second heat dissipation layer 652 may be composed substantially of, or entirely of, artificial graphite.

In an embodiment, the total thickness of the heat dissipation layer 650 (T1+T2) which is the sum of a thickness T1 of the first heat dissipation layer 651 and a thickness T2 of the second heat dissipation layer 652 may be in a range of about 50% to about 200% of a thickness T3 of the display panel 10. For example, in an embodiment, the total thickness of the heat dissipation layer 650 may be in a range of about 50% to about 150% of a thickness of the display panel 10. Here, the thickness T3 of the display panel 10 may mean a thickness from the substrate SUB of the display panel 10 to the encapsulation layer of the display panel 10. For example, the thickness T3 of the display panel 10 may mean a distance from a lower surface of the substrate SUB to an upper surface of the encapsulation layer in the third direction DR3. According to an embodiment, the total thickness of the heat dissipation layer 650 may be in a range of about 0.5 to about 1.5 mm.

According to an embodiment in which the heat dissipation layer 650 includes a plurality of heat dissipation layers 650, thicknesses of the heat dissipation layers 650 may be different from each other. For example, in an embodiment the thickness T1 of the first heat dissipation layer 651 may be greater than the thickness T2 of the second heat dissipation layer 652. According to an embodiment, a ratio of the thickness of the first heat dissipation layer 651 made of natural graphite to the thickness of the second heat dissipation layer 652 made of artificial graphite may be about 19:1. For example, when the thickness T1 of the first heat dissipation layer 651 is about 19, the thickness T2 of the second heat dissipation layer 652 may be about 1. According to an embodiment, the thickness ratio between the first heat dissipation layer 651 and the second heat dissipation layer 652 may be greater than about 19:1. For example, when the thickness T1 of the first heat dissipation layer 651 is about 820 $\mu$m, the thickness T2 of the second heat dissipation layer 652 may be about 100 $\mu$m.

According to an embodiment, the thermal conductivity of the first heat dissipation layer 651 may be lower than the thermal conductivity of the second heat dissipation layer 652. For example, in an embodiment the thermal conductivity of the first heat dissipation layer 651 may be about 240 W/mk, and the thermal conductivity of the second heat dissipation layer 652 may be about 1000 W/mk. In an embodiment, the thickness T1 of the first heat dissipation layer 651 may be greater than the thickness T2 of the second heat dissipation layer 652 as described above. For example, according to an embodiment, while the thermal conductivity of the first heat dissipation layer 651 made of natural graphite has a smaller value than the thermal conductivity of the second heat dissipation layer 652 made of artificial graphite, the thickness of the first heat dissipation layer 651 may have a greater value than the thickness of the second heat dissipation layer 652 (T1>T2).

According to an embodiment, the area of the first heat dissipation layer 651 and the area of the second heat dissipation layer 652 may be the same in a plan view (e.g., in a plane defined in the first and second directions DR1, DR2). For example, the area of the first heat dissipation layer 651 based on a size in the first direction DR1 and a size in the second direction DR2 may be the same as the area of the second heat dissipation layer 652 based on a size in the first direction DR1 and a size in the second direction DR2. For example, edges (e.g., ends) of the first heat dissipation layer 651 and edges (e.g., ends) of the second heat dissipation layer 652 may overlap each other in the third direction DR3 so that the entire area of the first heat dissipation layer 651 and the entire area of the second heat dissipation layer 652 overlap each other.

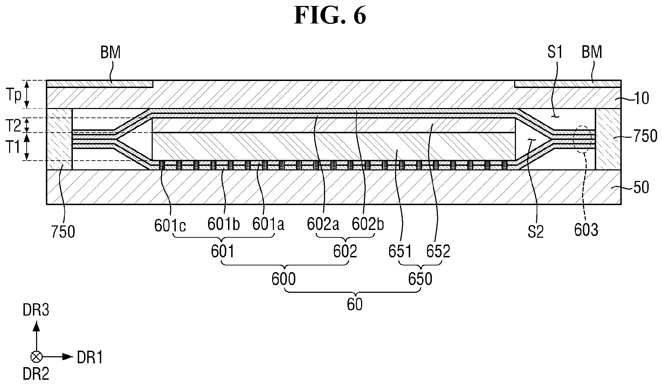

FIG. 6 is a cross-sectional view of a display device according to an embodiment.

The display device of FIG. 6 is different from the display device of FIG. 5 described above in that it further includes exhaust holes 601c. Therefore, this difference will be mainly described as follows and a repeated description of similar or identical elements may be omitted for economy of description.

As illustrated in FIG. 6, the display device may further include the exhaust holes 601c (e.g., air holes). The exhaust holes 601c may be disposed in a housing 600. For example, in an embodiment the exhaust holes 601c may be disposed in a surface of the housing 600 on a side opposite a contact surface between the housing 600 and a display panel 10. The exhaust holes 601c may penetrate the surface of the housing 600. For example, as shown in FIG. 6, the exhaust holes 601c may penetrate a first housing plate 601 of the housing 600 in the third direction DR3, such as an entirety of the first inner plate 601a and the first outer plate 601b. A plurality of exhaust holes 601c may be provided. In an embodiment, in a plan view, the exhaust holes 601c may have a circular shape. However, embodiments of the present disclosure are not necessarily limited thereto. The heated air inside the housing 600 may be released to the outside (e.g., the external environment) of the housing 600 through the exhaust holes 601c. Therefore, the heat dissipation effect of the heat dissipation member 60 can be further increased. While a plurality of exhaust holes 601c are shown in FIG. 6, in some embodiments the housing 600 may include at least one exhaust hole 601c.

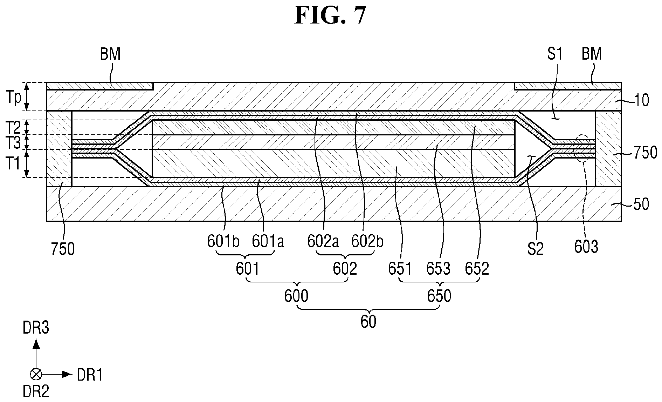

FIG. 7 is a cross-sectional view of a display device according to an embodiment.

The display device of FIG. 7 is different from the display device of FIG. 5 described above in that it further includes a third heat dissipation layer 653. Therefore, this difference will be mainly described as follows and a repeated description of similar or identical elements may be omitted for economy of description.

As illustrated in FIG. 7, the display device may further include the third heat dissipation layer 653. For example, a heat dissipation layer 650 may include a first heat dissipation layer 651, the third heat dissipation layer 653, and a second heat dissipation layer 652 sequentially stacked on a first inner plate 601a along the third direction DR3.

The third heat dissipation layer 653 may be disposed between the first heat dissipation layer 651 and the second heat dissipation layer 652 (e.g., in the third direction DR3). A surface of the third heat dissipation layer 653 may directly contact the first heat dissipation layer 651, and the other surface of the third heat dissipation layer 653 may directly contact the second heat dissipation layer 652. In an embodiment, the third heat dissipation layer 653 may have anisotropic thermal diffusion characteristics that spread more heat in the area direction (e.g., in the first direction DR1 and the second direction DR2 defining the area of the third heat dissipation layer 653 in a plan view) than in the thickness direction (e.g., the third reverse direction). In an embodiment, the third heat dissipation layer 653 may have a thickness T3 greater than a thickness of the second heat dissipation layer 652 and less than a thickness of the first heat dissipation layer 651 (T2<T3<T1). In an embodiment, the third heat dissipation layer 653 may have a thermal conductivity of about 202 W/mk. The third heat dissipation layer 653 may include metal. For example, the third heat dissipation layer 653 may include aluminum (Al). For example, the third heat dissipation layer 653 may be composed substantially of, or entirely of, metal, such as aluminum (Al).

A thickness ratio between the first heat dissipation layer 651, the third heat dissipation layer 653, and the second heat dissipation layer 652 may be, for example, about 16:3:1. For example, when the thickness T1 of the first heat dissipation layer 651 is about 16, the thickness T3 of the third heat dissipation layer 653 may be about 3, and the thickness T2 of the second heat dissipation layer 652 may be about 1. According to an embodiment, the thickness T1 of the first heat dissipation layer 651 may be about 820 $\mu$m (or 500 $\mu$m), the thickness T3 of the third heat dissipation layer 653 may be about 300 $\mu$m, and the thickness T2 of the second heat dissipation layer 652 may be about 100 $\mu$m.

According to an embodiment, the area of the first heat dissipation layer 651, the area of the third heat dissipation layer 653, and the area of the second heat dissipation layer 652 may be the same in a plan view. For example, the area of the first heat dissipation layer 651 based on a size in the first direction DR1 and a size in the second direction DR2, the area of the third heat dissipation layer 653 based on a size in the first direction DR1 and a size in the second direction DR2, and the area of the second heat dissipation layer 652 based on a size in the first direction DR1 and a size in the second direction DR2 may be equal to each other. In an embodiment, edges (e.g., ends) of the first heat dissipation layer 651, edges (e.g., ends) of the third heat dissipation layer 653, and edges (e.g., ends) of the second heat dissipation layer 652 may overlap each other in the third direction DR3 so that the entire area of the first heat dissipation layer 651, the entire area of the third heat dissipation layer 653, and the entire area of the second heat dissipation layer 652 overlap each other.

While an embodiment shown in FIG. 7 includes first to third heat dissipation layers 651, 652, 653, embodiments of the present disclosure are not necessarily limited thereto. For example, the heat dissipation member 60 may include a plurality of heat dissipation layers of varying numbers and each of the heat dissipation layers may have different thicknesses and different thermal conductivities from each other.

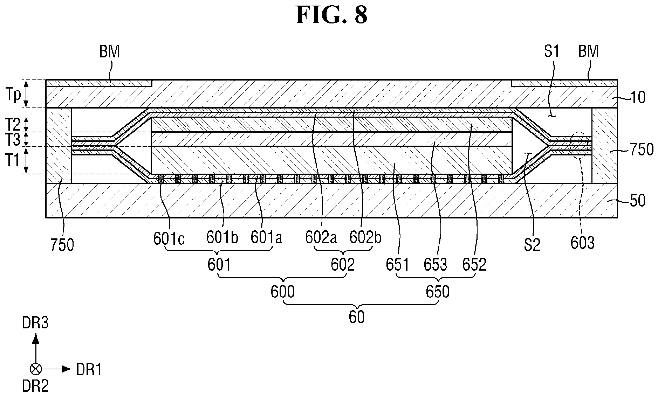

FIG. 8 is a cross-sectional view of a display device according to an embodiment.

The display device of FIG. 8 is different from the display device of FIG. 7 described above in that it further includes exhaust holes 601c. Therefore, this difference will be mainly described as follows and a repeated description of similar or identical elements may be omitted for economy of description.

As illustrated in FIG. 8, the display device may further include the exhaust holes 601c and the third heat dissipation layer 653. The exhaust holes 601c may be disposed in a housing 600. Since the exhaust holes 601c of FIG. 8 are substantially the same as the exhaust holes 601c of FIG. 6 described above, FIG. 6 and related descriptions may be referred to for a detailed description of the exhaust holes 601c of FIG. 8.

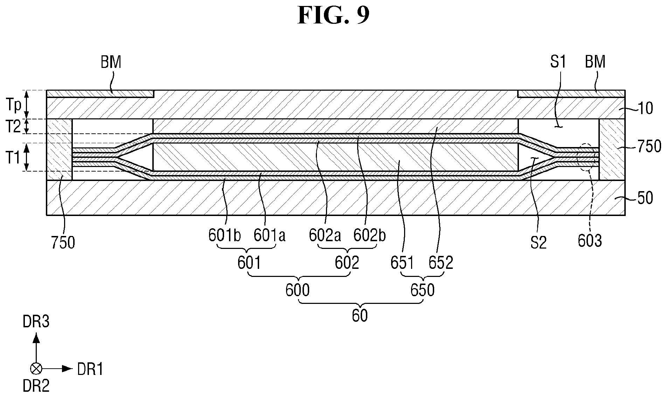

FIG. 9 is a cross-sectional view of a display device according to an embodiment.

The display device of an embodiment shown in FIG. 9 is different from the display device of an embodiment shown in FIG. 5 described above in the position of a second heat dissipation layer 652. Therefore, this difference will be mainly described as follows.

As illustrated in FIG. 9, in an embodiment in which a heat dissipation layer 650 includes a plurality of heat dissipation layers 650, at least one heat dissipation layer 650 may be disposed outside of the housing 600. For example, in an embodiment, among a first heat dissipation layer 651 and the second heat dissipation layer 652, the second heat dissipation layer 652 made of artificial graphite may be disposed outside the housing 600. As a specific example, the second heat dissipation layer 652 may be disposed between the housing 600 and a display panel 10. For example, the second heat dissipation layer 652 may be disposed between a second housing plate 602 and the display panel 10. For example, the second heat dissipation layer 652 may be disposed between a second outer plate 602b and a substrate SUB of the display panel 10 in a first space S 1.

In an embodiment, a surface of the second heat dissipation layer 652 may directly contact the housing 600 (e.g., the second outer plate 602b of the housing 600), and the other surface of the second heat dissipation layer 652 may directly contact the display panel 10 (e.g., the substrate SUB of the display panel 10).

In an embodiment, a surface of the first heat dissipation layer 651 may directly contact a first inner plate 601a of the housing 600, and the other surface of the first heat dissipation layer 651 may directly contact a second inner plate 602a of the housing 600.

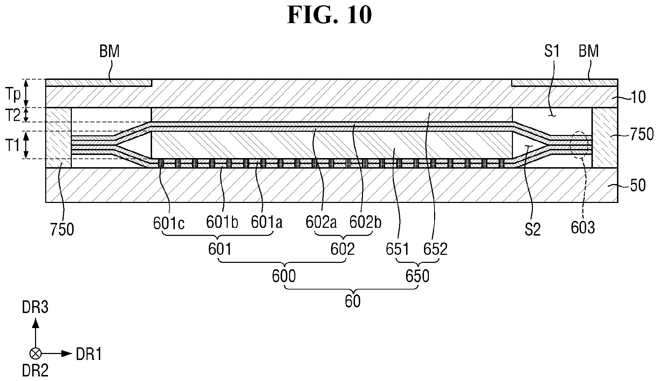

FIG. 10 is a cross-sectional view of a display device according to an embodiment.

The display device of FIG. 10 is different from the display device of FIG. 9 described above in that it further includes exhaust holes 601c. Therefore, this difference will be mainly described as follows and a repeated description of similar or identical elements may be omitted for economy of description.

As illustrated in FIG. 10, the display device may further include the exhaust holes 601c. The exhaust holes 601c may be disposed in a housing 600. Since the exhaust holes 601c of FIG. 10 are substantially the same as the exhaust holes 601c of FIG. 6 described above, FIG. 6 and related descriptions may be referred to for a detailed description of the exhaust holes 601c of FIG. 10.

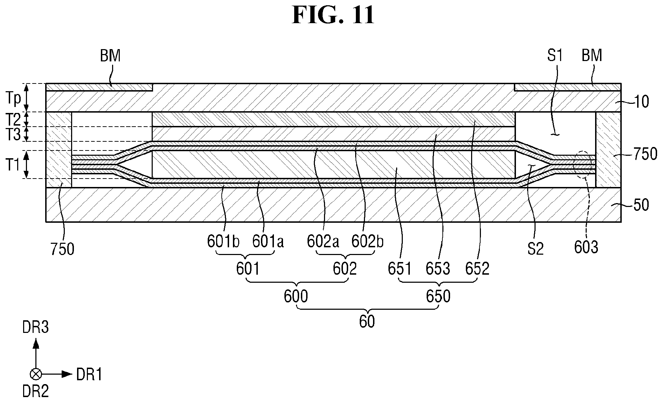

FIG. 11 is a cross-sectional view of a display device according to an embodiment.

The display device of FIG. 11 is different from the display device of FIG. 8 in the positions of a third heat dissipation layer 653 and a second heat dissipation layer 652. Therefore, this difference will be mainly described as follows and a repeated description of similar or identical elements may be omitted for economy of description.

As illustrated in FIG. 11, in an embodiment in which a heat dissipation layer 650 includes a plurality of heat dissipation layers 651, 653 and 652, at least one heat dissipation layer may be disposed outside a housing 600. The housing 600 may selectively surround at least one of the plurality of heat dissipation layers 651, 652, 653. For example, in an embodiment, among a first heat dissipation layer 651, the third heat dissipation layer 653, and the second heat dissipation layer 652, the third heat dissipation layer 653 made of metal and the second heat dissipation layer 652 made of artificial graphite may both be disposed outside the housing 600.

The third heat dissipation layer 653 may be disposed between the housing 600 and the second heat dissipation layer 652 (e.g., in the third direction DR3). For example, the third heat dissipation layer 653 may be disposed between a second housing plate 602 and the second heat dissipation layer 652. In an embodiment, the third heat dissipation layer 653 may be disposed between (e.g., directly therebetween) a second outer plate 602b and the second heat dissipation layer 652 in a first space S1. A surface of the third heat dissipation layer 653 may directly contact the second outer plate 602b, and the other surface of the third heat dissipation layer 653 may directly contact the second heat dissipation layer 652.

The second heat dissipation layer 652 may be disposed between the third heat dissipation layer 653 and a display panel 10 (e.g., in the third direction DR3). For example, the second heat dissipation layer 652 may be disposed between (e.g., directly therebetween) the third heat dissipation layer 653 and the display panel 10. In an embodiment, the second heat dissipation layer 652 may be disposed between the third heat dissipation layer 653 and a substrate SUB of the display panel 10 in the first space S1. A surface of the second heat dissipation layer 652 may directly contact the third heat dissipation layer 653, and the other surface of the second heat dissipation layer 652 may directly contact the substrate SUB of the display panel 10.

A surface of the first heat dissipation layer 651 may directly contact a first inner plate 601a of the housing 600, and the other surface of the first heat dissipation layer 651 may contact a second inner plate 602a of the housing 600.

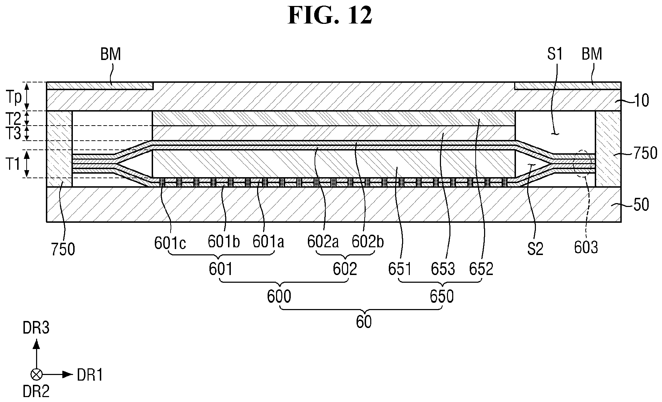

FIG. 12 is a cross-sectional view of a display device according to an embodiment.

The display device of FIG. 12 is different from the display device of FIG. 11 described above in that it further includes exhaust holes 601c. Therefore, this difference will be mainly described as follows and a repeated description of similar or identical elements may be omitted for economy of description.

As illustrated in FIG. 12, the display device may further include the exhaust holes 601c. The exhaust holes 601c may be disposed in a housing 600. Since the exhaust holes 601c of FIG. 12 are substantially the same as the exhaust holes 601c of FIG. 6 described above, FIG. 6 and related descriptions may be referred to for a detailed description of the exhaust holes 601c of FIG. 12.

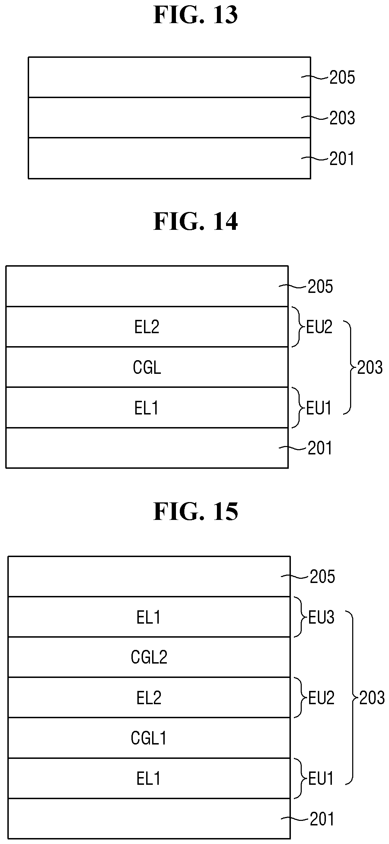

A light emitting element of each pixel included in a display device according to an embodiment may have a tandem structure, as will be described below with reference to FIGS. 13 through 20.

FIGS. 13 through 17 are cross-sectional views illustrating the structures of light emitting elements according to embodiments.

Referring to FIG. 13, a light emitting element (e.g., an organic light emitting diode) according to an embodiment may include a pixel electrode 201, a common electrode 205, and an intermediate layer 203 between the pixel electrode 201 and the common electrode 205 (e.g., in the third direction DR3).

In an embodiment, the pixel electrode 201 may include a light-transmitting conductive oxide such as indium tin oxide (ITO), indium zinc oxide (IZO), zinc oxide (ZnO), indium oxide ($In_2O_3$), indium gallium oxide (IGO), or aluminum zinc oxide (AZO). The pixel electrode 201 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. For example, in an embodiment the pixel electrode 201 may have a three-layer structure of ITO/Ag/ITO. However, embodiments of the present disclosure are not necessarily limited thereto.

The common electrode 205 may be disposed on the intermediate layer 203. In an embodiment, the common electrode 205 may include a metal having a low work function, an alloy, an electrically conductive compound, or any combination thereof. For example, the common electrode 205 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The common electrode 205 may be a transmissive electrode, a transflective electrode, or a reflective electrode.

In an embodiment, the intermediate layer 203 may include a high-molecular or low-molecular organic material that emits light of a predetermined color. In addition to various organic materials, the intermediate layer 203 may further include a metal-containing compound such as an organometallic compound, an inorganic material such as quantum dots, etc.

In an embodiment, the intermediate layer 203 may include one light emitting layer and a first functional layer and a second functional layer disposed below and above the light emitting layer, respectively. For example, in an embodiment the first functional layer may include a hole transport layer or may include a hole transport layer and a hole injection layer. The second functional layer is a component disposed on the light emitting layer and is optional. For example, the intermediate layer 203 may or may not include the second functional layer in some embodiments. The second functional layer may include an electron transport layer and/or an electron injection layer.

In an embodiment, the intermediate layer 203 may include two or more emitting units sequentially stacked between the pixel electrode 201 and the common electrode 205 and a charge generation layer disposed between the two emitting units. In an embodiment in which the intermediate layer 203 includes the emitting units and the charge generation layer, the light emitting element (e.g., the organic light emitting diode) may be a tandem light emitting element. The light emitting element (e.g., the organic light emitting diode) having a stacked structure of a plurality of emitting units can increase color purity and luminous efficiency.

One emitting unit may include a light emitting layer and a first functional layer and a second functional layer disposed below and above the light emitting layer, respectively. In an embodiment, the charge generation layer may include a negative charge generation layer and a positive charge generation layer. The luminous efficiency of the organic light emitting diode, which is a tandem light emitting element having a plurality of light emitting layers, can be further increased by the negative charge generation layer and the positive charge generation layer.

In an embodiment, the negative charge generation layer may be an n-type charge generation layer. The negative charge generation layer may supply electrons. The negative charge generation layer may include a host and a dopant. The host may include an organic material. The dopant may include a metallic material. The positive charge generation layer may be a p-type charge generation layer. The positive charge generation layer may supply holes. The positive charge generation layer may include a host and a dopant. The host may include an organic material. The dopant may include a metallic material.

In an embodiment, as illustrated in FIG. 14, a light emitting element (e.g., an organic light emitting diode) may include a first emitting unit EU1 including a first light emitting layer EL1 and a second emitting unit EU2 including a second light emitting layer EL2 which are stacked sequentially (e.g., in the third direction DR3). A charge generation layer CGL may be disposed between the first emitting unit EU1 and the second emitting unit EU2 (e.g., in the third direction DR3). For example, in an embodiment the light emitting element (e.g., the organic light emitting diode) may include a pixel electrode 201, the first light emitting layer EL1, the charge generation layer CGL, the second light emitting layer EL2, and a common electrode 205 which are stacked sequentially (e.g., in the third direction DR3). A first functional layer and a second functional layer may be disposed below and above the first light emitting layer EL1, respectively. A first functional layer and a second functional layer may be disposed below and above the second light emitting layer EL2, respectively. In an embodiment, the first light emitting layer EL1 may be a blue light emitting layer, and the second light emitting layer EL2 may be a yellow light emitting layer. However, embodiments of the present disclosure are not necessarily limited thereto.

In an embodiment, as illustrated in FIG. 15, a light emitting element (e.g., an organic light emitting diode) may include a first emitting unit EU1 and a third emitting unit EU3, each including a first light emitting layer EL1, and a second emitting unit EU2 including a second light emitting layer EL2. In an embodiment, a first charge generation layer CGL1 may be disposed between the first emitting unit EU1 and the second emitting unit EU2 (e.g., in the third direction DR3), and a second charge generation layer CGL2 may be disposed between the second emitting unit EU2 and the third emitting unit EU3 (e.g., in the third direction DR3). For example, the light emitting element (e.g., the organic light emitting diode) may include a pixel electrode 201, the first light emitting layer EL1, the first charge generation layer CGL1, the second light emitting layer EL2, the second charge generation layer CGL2, the first light emitting layer EL1, and a common electrode 205 which are stacked sequentially (e.g., in the third direction DR3). In an embodiment, a first functional layer and a second functional layer may be disposed below and above the first light emitting layer EL1, respectively. A first functional layer and a second functional layer may be disposed below and above the second light emitting layer EL2, respectively. In an embodiment, the first light emitting layer EL1 may be a blue light emitting layer, and the second light emitting layer EL2 may be a yellow light emitting layer. However, embodiments of the present disclosure are not necessarily limited thereto.

In an embodiment, the light emitting element (e.g., the organic light emitting diode) may further include a third light emitting layer EL3 and/or a fourth light emitting layer EL4 disposed below and/or above the second light emitting layer EL2 to directly contact the second light emitting layer EL2, in addition to the second light emitting layer EL2. The term "directly contact" may mean that no other layer is disposed between the second light emitting layer EL2 and the third light emitting layer EL3 and/or between the second light emitting layer EL2 and the fourth light emitting layer EL4. In an embodiment, the third light emitting layer EL3 may be a red light emitting layer, and the fourth light emitting layer EL4 may be a green light emitting layer. However, embodiments of the present disclosure are not necessarily limited thereto.

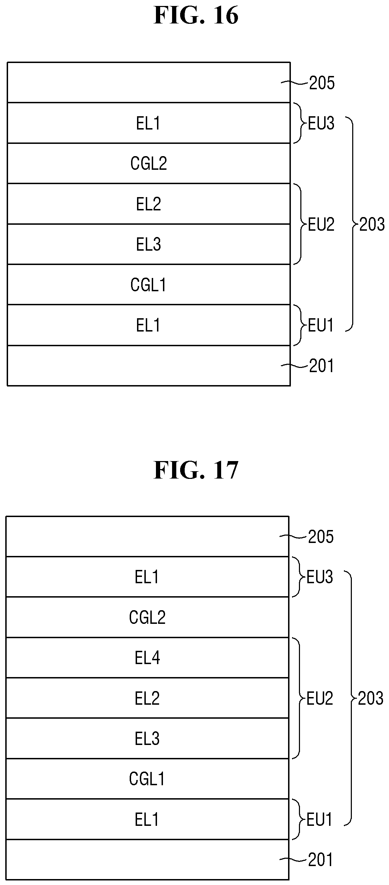

For example, as illustrated in FIG. 16, a light emitting element (e.g., an organic light emitting diode) may include a pixel electrode 201, a first light emitting layer EL1, a first charge generation layer CGL1, a third light emitting layer EL3, a second light emitting layer EL2, a second charge generation layer CGL2, a first light emitting layer EL1, and a common electrode 205 which are stacked sequentially (e.g., in the third direction DR3). Alternatively, as illustrated in FIG. 17, a light emitting element (e.g., an organic light emitting diode) may include a pixel electrode 201, a first light emitting layer EL1, a first charge generation layer CGL1, a third light emitting layer EL3, a second light emitting layer EL2, a fourth light emitting layer EL4, a second charge generation layer CGL2, a first light emitting layer EL1, and a common electrode 205 which are stacked sequentially (e.g., in the third direction DR3).

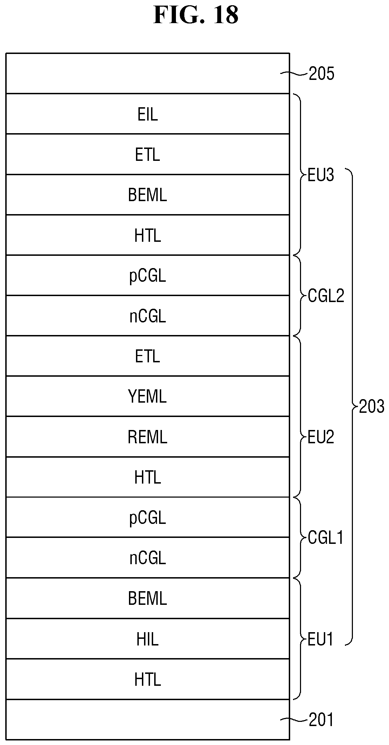

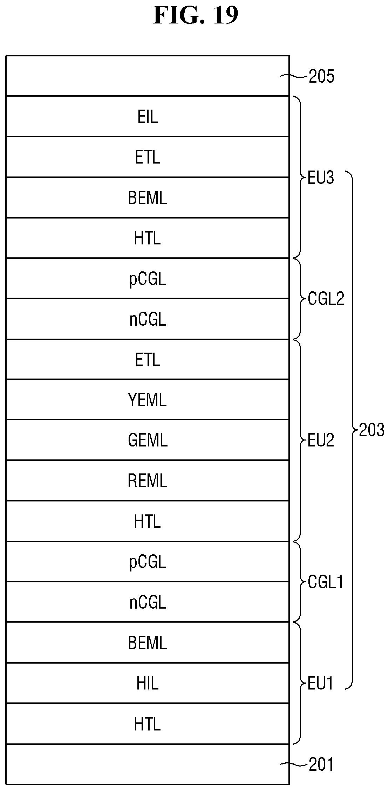

FIG. 18 is a cross-sectional view illustrating an example of the organic light emitting diode of FIG. 16. FIG. 19 is a cross-sectional view illustrating an example of the organic light emitting diode of FIG. 17.

Referring to FIG. 18, a light emitting element (e.g., an organic light emitting diode) may include a first emitting unit EU1, a second emitting unit EU2, and a third emitting unit EU3 stacked sequentially (e.g., in the third direction DR3). A first charge generation layer CGL1 may be disposed between the first emitting unit EU1 and the second emitting unit EU2 (e.g., in the third direction DR3), and a second charge generation layer CGL2 may be disposed between the second emitting unit EU2 and the third emitting unit EU3 (e.g., in the third direction DR3). In an embodiment, the first charge generation layer CGL1 and the second charge generation layer CGL2 may each include a negative charge generation layer nCGL and a positive charge generation layer pCGL.

In an embodiment, the first emitting unit EU1 may include a blue light emitting layer BEML. The first emitting unit EU1 may further include a hole injection layer HIL and a hole transport layer HTL between a pixel electrode 201 and the blue light emitting layer BEML. In an embodiment, a p-doped layer may be further included between the hole injection layer HIL and the hole transport layer HTL. The p-doped layer may be formed by doping the hole injection layer HIL with a p-type doping material. In an embodiment, at least one of a blue light auxiliary layer, an electron blocking layer, and a buffer layer may be further included between the blue light emitting layer BEML and the hole transport layer HTL. The blue light auxiliary layer may increase the light emission efficiency of the blue light emitting layer BEML. For example, the blue light auxiliary layer may increase the light emission efficiency of the blue light emitting layer BEML by adjusting a hole charge balance. The electron blocking layer may prevent injection of electrons into the hole transport layer HTL. The buffer layer may compensate for a resonance distance according to the wavelength of light emitted from a light emitting layer.

In an embodiment, the second emitting unit EU2 may include a yellow light emitting layer YEML and a red light emitting layer REML disposed below the yellow light emitting layer YEML to directly contact the yellow light emitting layer YEML. The second emitting unit EU2 may further include a hole transport layer HTL between the positive charge generation layer pCGL of the first charge generation layer CGL1 and the red light emitting layer REML and may further include an electron transport layer ETL between the yellow light emitting layer YEML and the negative charge generation layer nCGL of the second charge generation layer CGL2.

In an embodiment, the third emitting unit EU3 may include a blue light emitting layer BEML. The third emitting unit EU3 may further include a hole transport layer HTL between the positive charge generation layer pCGL of the second charge generation layer CGL2 and the blue light emitting layer BEML. The third emitting unit EU3 may further include an electron transport layer ETL and an electron injection layer EII, between the blue light emitting layer BEML and a common electrode 205. The electron transport layer ETL may be a single layer or a multilayer. In an embodiment, at least one of a blue light auxiliary layer, an electron blocking layer, and a buffer layer may be further included between the blue light emitting layer BEML and the hole transport layer HTL. At least one of a hole blocking layer and a buffer layer may be further included between the blue light emitting layer BEML and the electron transport layer ETL. The hole blocking layer may prevent injection of holes into the electron transport layer ETL.

A light emitting element (e.g., an organic light emitting diode) illustrated in FIG. 19 is the same as the light emitting element (e.g., the organic light emitting diode) illustrated in FIG. 18 except for the stacked structure of a second emitting unit EU2. Referring to FIG. 19, the second emitting unit EU2 may include a green light emitting layer GEML, a red light emitting layer REML disposed below the green light emitting layer GEML to directly contact the green light emitting layer GEML, and a yellow light emitting layer YEML disposed above the green light emitting layer GEML to directly contact the green light emitting layer GEML. The second emitting unit EU2 may further include a hole transport layer HTL between a positive charge generation layer pCGL of a first charge generation layer CGL1 and the red light emitting layer REML and may further include an electron transport layer ETL between the yellow light emitting layer YEML and a negative charge generation layer nCGL of a second charge generation layer CGL2.

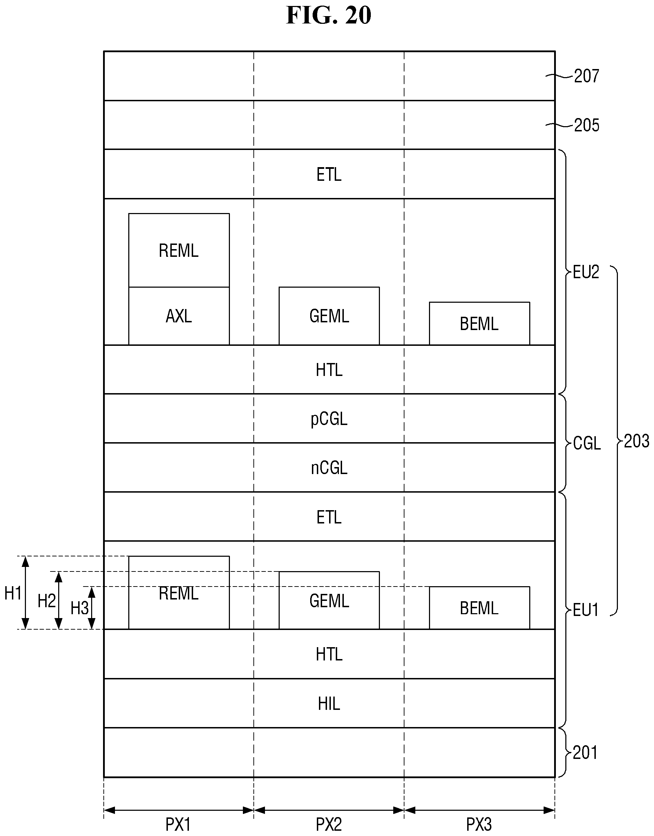

FIG. 20 is a cross-sectional view illustrating the pixel structure of a display device 1000 according to an embodiment.

Referring to FIG. 20, a display panel 400 of the display device 1000 may include a plurality of pixels. In an embodiment, the pixels may include a first pixel PX1, a second pixel PX2, and a third pixel PX3. Each of the first pixel PX1, the second pixel PX2, and the third pixel PX3 may include a pixel electrode 201, a common electrode 205, and an intermediate layer 203. In an embodiment, the first pixel PX1 may be a red pixel, the second pixel PX2 may be a green pixel, and the third pixel PX3 may be a blue pixel. However, embodiments of the present disclosure are not necessarily limited thereto.

In an embodiment, the pixel electrode 201 may be independently provided in each of the first pixel PX1, the second pixel PX2, and the third pixel PX3.

In an embodiment, the intermediate layer 203 of each of the first pixel PX1, the second pixel PX2, and the third pixel PX3 may include a first emitting unit EU1 and a second emitting unit EU2 stacked sequentially and a charge generation layer CGL between the first emitting unit EU1 and the second emitting unit EU2 (e.g., in the third direction DR3). The charge generation layer CGL may include a negative charge generation layer nCGL and a positive charge generation layer pCGL. The charge generation layer CGL may be a common layer continuously formed in the first pixel PX1, the second pixel PX2, and the third pixel PX3.

In an embodiment, the first emitting unit EU1 of the first pixel PX1 may include a hole injection layer HIL, a hole transport layer HTL, a red light emitting layer REML, and an electron transport layer ETL sequentially stacked on the pixel electrode 201 (e.g., in the third direction DR3). The first emitting unit EU1 of the second pixel PX2 may include the hole injection layer HIL, the hole transport layer HTL, a green light emitting layer GEML, and the electron transport layer ETL sequentially stacked on the pixel electrode 201 (e.g., in the third direction DR3). The first emitting unit EU1 of the third pixel PX3 may include the hole injection layer HIL, the hole transport layer HTL, a blue light emitting layer BEML, and the electron transport layer ETL sequentially stacked on the pixel electrode 201 (e.g., in the third direction DR3). In an embodiment, each of the hole injection layer HIL, the hole transport layer HTL, and the electron transport layer ETL of the first emitting units EU1 may be a common layer formed continuously in the first pixel PX1, the second pixel PX2, and the third pixel PX3.

In an embodiment, the second emitting unit EU2 of the first pixel PX1 may include a hole transport layer HTL, an auxiliary layer AXL, a red light emitting layer REML, and an electron transport layer ETL sequentially stacked on the charge generation layer CGL (e.g., in the third direction DR3). The second emitting unit EU2 of the second pixel PX2 may include the hole transport layer HTL, a green light emitting layer GEML, and the electron transport layer ETL sequentially stacked on the charge generation layer CGL (e.g., in the third direction DR3). The second emitting unit EU2 of the third pixel PX3 may include the hole transport layer HTL, a blue light emitting layer BEML, and the electron transport layer ETL sequentially stacked on the charge generation layer CGL. In an embodiment, each of the hole transport layer HTL and the electron transport layer ETL of the second emitting units EU2 may be a common layer continuously formed in the first pixel PX1, the second pixel PX2, and the third pixel PX3. In an embodiment, at least one of a hole blocking layer and a buffer layer may be further included between a light emitting layer and the electron transport layer ETL in each of the second emitting units EU2 of the first pixel PX1, the second pixel PX2, and the third pixel PX3.

A thickness H1 of the red light emitting layer REML, a thickness H2 of the green light emitting layer GEML, and a thickness H3 of the blue light emitting layer BEML may be determined according to a resonance distance. The auxiliary layer AXL is a layer added to adjust the resonance distance and may include a resonance auxiliary material. For example, the auxiliary layer AXL may include the same material as the hole transport layer HTL.

In FIG. 20, the auxiliary layer AXL is disposed only in the first pixel PX1. However, embodiments of the present disclosure are not necessarily limited thereto. For example, the auxiliary layer AXL may be disposed in at least one of the first pixel PX1, the second pixel PX2, and the third pixel PX3 to adjust the resonance distance of each of the first pixel PX1, the second pixel PX2, and the third pixel PX3.

The display panel 400 of the display device 1000 may further include a capping layer 207 disposed outside the common electrode 205. For example, in an embodiment the capping layer 207 may be disposed directly above the common electrode 205 (e.g., in the third direction DR3). The capping layer 207 may increase luminous efficiency through the principle of constructive interference. Accordingly, the light extraction efficiency of a light emitting element (e.g., an organic light emitting diode) can be increased, and thus the luminous efficiency of the light emitting element (e.g., the organic light emitting diode) can be increased.

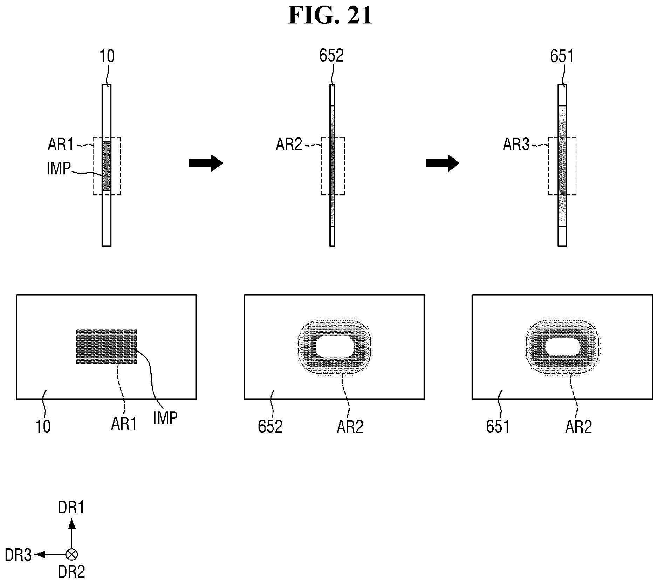

FIG. 21 is a diagram for explaining the effect of a display device according to an embodiment. For example, FIG. 21 is a diagram for explaining the heat dissipation effect of the display device of FIG. 5 described above.

First, a second heat dissipation layer 652 in FIG. 21 may include an artificial graphite material, a thickness T2 of the second heat dissipation layer 652 may be about 100 $\mu$m, and the thermal conductivity of the second heat dissipation layer 652 may be about 1000 W/mk. In addition, a first heat dissipation layer 651 in FIG. 21 may include a natural graphite material, a thickness T1 of the first heat dissipation layer 651 may be about 820 $\mu$m, and the thermal conductivity of the first heat dissipation layer 651 may be about 240 W/mk.

In FIG. 21, arrows pointing in the third reverse direction indicate a heat dissipation direction of a display panel 10.

As illustrated in FIG. 21, an image pattern IMP may be displayed in a rectangular shape in the center of a display area of the display panel 10. The image pattern IMP may include, for example, pixels that provide light with the luminance of a highest gray level. For example, the pixels that display the image pattern IMP may include an organic light emitting diode that emits light with the luminance of full white.

Due to the full-white image pattern IMP, high heat may be generated from an area AR1 of the display panel 10 (e.g., an image pattern area AR1) which corresponds to the image pattern IMP. The heat of the image pattern area AR1 may be transferred to the second heat dissipation layer 652. Then, the heat may spread around an area AR2 of the second heat dissipation layer 652 which corresponds to the image pattern area AR1. In the area AR2 of the second heat dissipation layer 652 which corresponds to the image pattern area AR1, the temperature may be highest in the center of the area AR2 and may decrease as a distance from the center of the area AR2 increases. In an embodiment, since the second heat dissipation layer 652 has a smaller thickness than the first heat dissipation layer 651, the second heat dissipation layer 652, as compared with the first heat dissipation layer 651, may spread more heat in its area direction (e.g., the first direction DR1 and the second direction DR2) than in its thickness direction (e.g., the third reverse direction).

The heat from the second heat dissipation layer 652 may be transferred to the first heat dissipation layer 651. Then, the heat may spread around an area AR3 of the first heat dissipation layer 651 which corresponds to the image pattern area AR1. In the area AR3 of the first heat dissipation layer 651 which corresponds to the image pattern area AR1, temperature may be highest in the center of the area AR3 and may decrease as a distance from the center of the area AR3 increases. In an embodiment, since the second heat dissipation layer 652 has a smaller thickness than the first heat dissipation layer 651, the first heat dissipation layer 651, as compared with the second heat dissipation layer 652, may spread more heat in its thickness direction (e.g., the third reverse direction) than in its area direction (e.g., the first direction DR1 and the second direction DR2).

Since the first heat dissipation layer 651 and the second heat dissipation layer 652 have different thermal conductivities and different thicknesses as described above, more heat may be spread in the first and second directions DR1 and DR2 in the second heat dissipation layer 652 made of artificial graphite, whereas more heat is spread in the third reverse direction in the first heat dissipation layer 651 made of natural graphite. Therefore, the heat spread evenly in the second heat dissipation layer 652 in the area direction (e.g., the first and second directions DR1 and DR2 defining the area of the second heat dissipation layer 652 in a plan view) may be dissipated through the first heat dissipation layer 651 in the thickness direction (e.g., the third reverse direction). Thus, the heat transferred to the second heat dissipation layer 652 may not be concentrated in the area corresponding to the image pattern area AR1 but may be spread evenly in the area direction of the second heat dissipation layer 652 (e.g., in the first and second directions DR1, DR2). Therefore, the heat of the second heat dissipation layer 652 can be dissipated more quickly through the first heat dissipation layer 651. Accordingly, the heat in the display panel 10 can be dissipated more effectively. In addition, a screen afterimage (e.g., a thermal instantaneous afterimage) that is generated when heat is concentrated in a specific area AR1 by a specific image pattern IMP is removed or prevented. Therefore, the image quality of the display device can be increased.

<Equation 1>

$$Qcond = -kA(\Delta T/\Delta x) \qquad \qquad \ldots(1).$$

Equation 1 above is an equation concerning thermal conductivity (Qcond). In Equation 1 above, k is the thermal conductivity of a heat dissipation layer (e.g., the thermal conductivity of a material used as a heat dissipation layer 650), $A$ is the area of the heat dissipation layer (e.g., the area of the heat dissipation layer defined by the first direction DR1 and the second direction DR2), and ($\Delta T/\Delta x$) is a temperature gradient. $\Delta T$ is a temperature difference between heat provided to the heat dissipation layer and heat passing through the heat dissipation layer, and $\Delta x$ is a thickness of the heat dissipation layer 650.

Since the second heat dissipation layer 652 has a large area (A) compared with its thickness, heat is spread evenly in the area direction of the second heat dissipation layer 652. Accordingly, the amount of heat spread and transferred through the second heat dissipation layer 652 and the first heat dissipation layer 621 may increase.

The display device of an embodiment illustrated in FIG. 21 may have a low just-noticeable difference (JND) value. For example, the display device according to an embodiment of FIG. 21 may have an increased JND of 7.3 based on 2.6 JND.

The JND refers to a difference in physical stimulation that causes a least sensory difference. For example, the JND refers to a minimum difference in luminance, saturation, and color that allows a person to perceive an afterimage. As the JND value is lower, afterimages of the display device are reduced, thereby increasing the image quality of the display device.

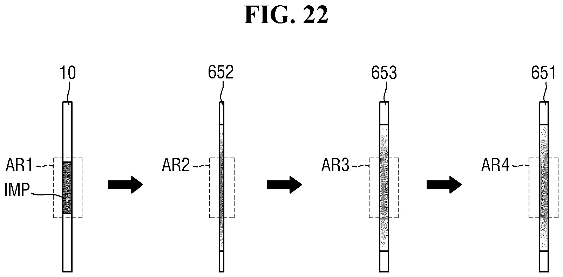

FIG. 22 is a diagram for explaining the effect of a display device according to an embodiment. For example, FIG. 22 is a diagram for explaining the heat dissipation effect of the display device of FIG. 7 described above.

First, a second heat dissipation layer 652 in FIG. 22 may include an artificial graphite material, a thickness T2 of the second heat dissipation layer 652 may be about 100 $\mu$m, and the thermal conductivity of the second heat dissipation layer 652 may be about 1000 W/mk. In addition, a third heat dissipation layer 653 in FIG. 22 may include an aluminum material, a thickness T3 of the third heat dissipation layer 653 may be about 300 $\mu$m, and the thermal conductivity of the third heat dissipation layer 653 may be about 202 W/mk. In addition, a first heat dissipation layer 651 in FIG. 22 may include a natural graphite material, a thickness T1 of the first heat dissipation layer 651 may be about 820 $\mu$m, and the thermal conductivity of the first heat dissipation layer 651 may be about 240 W/mk.

In FIG. 22, arrows pointing in the third reverse direction indicate a heat dissipation direction of a display panel 10.

As illustrated in FIG. 22, an image pattern IMP may be displayed in a rectangular shape in the center of a display area of the display panel 10. The image pattern IMP may include, for example, pixels that provide light with the luminance of a highest gray level. For example, the pixels that display the image pattern IMP may include an organic light emitting diode that emits light with the luminance of full white.

Due to the full-white image pattern IMP, high heat may be generated from an area AR1 of the display panel 10 which corresponds to the image pattern IMP. The heat of the image pattern area AR1 may be transferred to the second heat dissipation layer 652. Then, the heat may spread around an area A2 of the second heat dissipation layer 652 which corresponds to the image pattern area AR1. In the area AR2 of the second heat dissipation layer 652 which corresponds to the image pattern area AR1, temperature may be highest in the center of the area AR2 and may decrease as a distance from the center of the area AR2 increases. In an embodiment, since the second heat dissipation layer 652 has a relatively small thickness, more heat may be spread in an area direction (e.g., the first direction DR1 and the second direction DR2) of the second heat dissipation layer 652 than in a thickness direction (e.g., the third reverse direction) of the second heat dissipation layer 652.

The heat from the second heat dissipation layer 652 may be transferred to the third heat dissipation layer 653. Then, the heat may spread around an area A3 of the third heat dissipation layer 653 which corresponds to the image pattern area AR1. In the area AR3 of the third heat dissipation layer 653 which corresponds to the image pattern area AR1, temperature may be highest in the center of the area AR3 and may decrease as a distance from the center of the area AR3 increases. In an embodiment, the third heat dissipation layer 653 may be a metal layer, and the heat may be spread evenly in the thickness direction and area direction of the third heat dissipation layer 653.

The heat from the third heat dissipation layer 653 may be transferred to the first heat dissipation layer 651. Then, the heat may spread around an area A4 of the first heat dissipation layer 651 which corresponds to the image pattern area AR1. In the area AR4 of the first heat dissipation layer 651 which corresponds to the image pattern area AR1, temperature may be highest in the center of the area AR4 and may decrease as a distance from the center of the area AR4 increases. In an embodiment, since the first heat dissipation layer 651 has a relatively large thickness, more heat may be spread in the thickness direction (e.g., the third reverse direction) of the first heat dissipation layer 651 than in the area direction (e.g., the first direction DR1 and the second direction DR2) of the first heat dissipation layer 651.

Since the first heat dissipation layer 651, the third heat dissipation layer 653, and the second heat dissipation layer 652 have different thermal conductivities and different thicknesses from each other as described above, more heat may be spread in the first and second directions DR1 and DR2 in the second heat dissipation layer 652 made of artificial graphite, whereas more heat is spread in the third reverse direction in the first heat dissipation layer 651 made of natural graphite. In addition, since the third heat dissipation layer 653 made of a metal material is disposed between the second heat dissipation layer 652 and the first heat dissipation layer 651, the heat of the second heat dissipation layer 652 can be evenly spread to the first heat dissipation layer 651. Therefore, the heat spread evenly in the second heat dissipation layer 652 in the area direction (e.g., the first and second directions DR1 and DR2) can be dissipated through the third heat dissipation layer 653 and the first heat dissipation layer 651 in the thickness direction (e. g., the third reverse direction). For example, the heat transferred to the second heat dissipation layer 652 may not be concentrated in the area A2 corresponding to the image pattern area AR1 but may be spread evenly in the area direction (e.g., the first and second directions DR1, DR2) of the second heat dissipation layer 652. Therefore, the heat of the second heat dissipation layer 652 can be dissipated more quickly through the third heat dissipation layer 653 and the first heat dissipation layer 651. Accordingly, the heat in the display panel 10 can be dissipated more effectively. In addition, a screen afterimage (e.g., a thermal instantaneous afterimage) that is generated when heat is concentrated in a specific area AR1 by a specific image pattern IMP is removed or prevented. Therefore, the image quality of the display device can be increased.

The display device of an embodiment illustrated in FIG. 22 may have a low JND value. For example, the display device according to an embodiment of FIG. 22 may have an increased JND of 7.6 based on 2.6 JND.

In an organic light emitting diode display device according to the present disclosure, heat dissipation speed can be increased. In addition, since afterimages are minimized or prevented, image quality can be increased.

However, the effects of the present disclosure are not restricted to the ones set forth herein.

In concluding the detailed description, those skilled in the art will appreciate that many variations and modifications can be made to the described embodiments without substantially departing from the principles of the present disclosure. Therefore, the described embodiments of the present disclosure are used in a generic and descriptive sense only and not for purposes of limitation.

**Claims**

1.    An organic light emitting diode display device comprising:

a display panel (10, 400) comprising an organic light emitting diode; and
a heat dissipation member (60) facing the display panel (10, 400),
wherein the heat dissipation member (60) comprises a plurality of heat dissipation layers (650, 651, 652) having different thicknesses and different thermal conductivities from each other.

2. The organic light emitting diode display device of claim 1, wherein the plurality of heat dissipation layers (650, 651, 652) comprises:

a first heat dissipation layer (621, 651); and
a second heat dissipation layer (652) between the first heat dissipation layer (621, 651) and the display panel (10, 400).

3. The organic light emitting diode display device of claim 2, wherein:

the second heat dissipation layer (652) has a higher thermal conductivity than a thermal conductivity of the first heat dissipation layer (621, 651); and
the second heat dissipation layer (652) has a thickness that is less than a thickness of the first heat dissipation layer (621, 651).

4. The organic light emitting diode display device of claim 2 or 3, wherein a ratio between the thickness of the first heat dissipation layer (621, 651) and the thickness of the second heat dissipation layer (652) is 19: 1, and/or wherein:

the first heat dissipation layer (621, 651) has a thickness of 820 $\mu$m and a thermal conductivity of 240 W/mk; and
the second heat dissipation layer (652) has a thickness of 100 $\mu$m and a thermal conductivity of 1000 W/mk.

5. The organic light emitting diode display device of any of claims 2 to 4, wherein:

the first heat dissipation layer (621, 651) comprises natural graphite; and
the second heat dissipation layer (652) comprises artificial graphite, and/or
wherein the first heat dissipation layer (621, 651) has thermal diffusion characteristics that spreads more of the heat generated by the display panel (10, 400) in a thickness direction of the heat dissipation member (60) than in the first and second directions as compared with the second heat dissipation layer (652).

6. The organic light emitting diode display device of claim 1, wherein the plurality of heat dissipation layers (650, 651, 652) comprises:

a first heat dissipation layer (621, 651);
a second heat dissipation layer (652) between the first heat dissipation layer (621, 651) and the display panel (10, 400); and
a third heat dissipation layer (651, 652, 653) between the first heat dissipation layer (621, 651) and the second heat dissipation layer (652).

7. The organic light emitting diode display device of claim 6, wherein:

the third heat dissipation layer (651, 652, 653) has a thickness greater than a thickness of the second heat dissipation layer (652) and less than a thickness of the first heat dissipation layer (621, 651); and
the first heat dissipation layer (621, 651) has a thermal conductivity higher than thermal conductivity of the third heat dissipation layer (651, 652, 653) and lower than a thermal conductivity of the second heat dissipation layer (652).

8. The organic light emitting diode display device of claim 6 or 7, wherein:

a ratio between the thickness of the first heat dissipation layer (621, 651), the thickness of the third heat dissipation layer (651, 652, 653), and the thickness of the second heat dissipation layer (652) is 16:3:1, and/or wherein:

the first heat dissipation layer (621, 651) has a thickness of 500 $\mu$m or 820 $\mu$m and a thermal conductivity of 240 W/mk;
the second heat dissipation layer (652) has a thickness of 100 $\mu$m and a thermal conductivity of 1000 W/mk;

and
the third heat dissipation layer (651, 652, 653) has a thickness of 300 $\mu$m and a thermal conductivity of 202 W/mk.

9.  The organic light emitting diode display device of any of claims 6 to 8, wherein:

    the first heat dissipation layer comprises natural graphite; the third heat dissipation layer comprises metal; and the second heat dissipation layer comprises artificial graphite.

10. The organic light emitting diode display device of claim 9, wherein the third heat dissipation layer (651, 652, 653) comprises aluminum.

11. The organic light emitting diode display device of any of the preceding claims, further comprising a housing (600) surrounding the plurality of heat dissipation layers (650, 651, 652), and/or wherein the housing (600) has at least one exhaust hole (601c) penetrating the housing (600).

12. The organic light emitting diode display device of claim 11, wherein:

    the housing (600) includes a first surface and a second surface facing each other, wherein the second surface is disposed closer to the display panel (10, 400) than the first surface; and
    the at least one exhaust hole (601c) penetrates the second surface of the housing (600).

13. The organic light emitting diode display device of any of claims 1 to 10, further comprising a housing (600) selectively surrounding at least one of the plurality of heat dissipation layers (650, 651, 652).

14. The organic light emitting diode display device of claim 13, wherein:

    the plurality of heat dissipation layers (650, 651, 652) comprise a first heat dissipation layer (621, 651) and a second heat dissipation layer (652) between the first heat dissipation layer (621, 651) and the display panel (10, 400); and
    the housing (600) surrounds the first heat dissipation layer (621, 651), or wherein:
    the plurality of heat dissipation layers (650, 651, 652) comprise a first heat dissipation layer (621, 651), a second heat dissipation layer (652) between the first heat dissipation layer (621, 651) and the display panel (10, 400) and a third heat dissipation layer (651, 652, 653) between the first heat dissipation layer (621, 651) and the second heat dissipation layer (652); and
    the housing (600) surrounds the first heat dissipation layer (621, 651).

15. The organic light emitting diode display device of any of the preceding claims 1, wherein a total thickness of the plurality of heat dissipation layers (650, 651, 652) is in a range of 50% to 150% of a thickness of the display panel (10, 400), and/or wherein the total thickness of the plurality of heat dissipation layers (650, 651, 652) is in a range of 0.5 mm to 1.5 mm.

# FIG. 1

# FIG. 2

EXD  NDA2

1

PX PX PX
PX PX PX
PX PX PX

SDR

DPA

NDA4

NDA3

EXD  DIC

NDA1

DR1
DR3
DR2

NDA : NDA1, NDA2, NDA3, NDA4

# FIG. 3

# FIG. 4

# FIG. 5

# FIG. 6

# FIG. 7

## FIG. 8

# FIG. 9

# FIG. 10

## FIG. 11

# FIG. 12

# FIG. 13

| | |
|---|---|
| | ~205 |
| | ~203 |
| | ~201 |

# FIG. 14

| | |
|---|---|
| | ~205 |
| EL2 | }EU2 |
| CGL | }203 |
| EL1 | }EU1 |
| | ~201 |

# FIG. 15

| | |
|---|---|
| | ~205 |
| EL1 | }EU3 |
| CGL2 | |
| EL2 | }EU2 }203 |
| CGL1 | |
| EL1 | }EU1 |
| | ~201 |

# FIG. 16

| | |
|---|---|
| | 205 |
| EL1 | EU3 |
| CGL2 | |
| EL2 | EU2 |
| EL3 | 203 |
| CGL1 | |
| EL1 | EU1 |
| | 201 |

# FIG. 17

| | |
|---|---|
| | 205 |
| EL1 | EU3 |
| CGL2 | |
| EL4 | |
| EL2 | EU2 |
| EL3 | 203 |
| CGL1 | |
| EL1 | EU1 |
| | 201 |

32

# FIG. 18

| | |
|---|---|
| | 205 |
| EIL | |
| ETL | |
| BEML | EU3 |
| HTL | |
| pCGL | |
| nCGL | CGL2 |
| ETL | |
| YEML | |
| REML | EU2 |
| HTL | |
| pCGL | |
| nCGL | CGL1 |
| BEML | |
| HIL | EU1 |
| HTL | |
| | 201 |

203

# FIG. 19

| | |
|---|---|
| | 205 |
| EIL | |
| ETL | |
| BEML | EU3 |
| HTL | |
| pCGL | |
| nCGL | CGL2 |
| ETL | |
| YEML | |
| GEML | EU2 |
| REML | |
| HTL | |
| pCGL | |
| nCGL | CGL1 |
| BEML | |
| HIL | EU1 |
| HTL | |
| | 201 |

203

# FIG. 20

| | | | |
|---|---|---|---|
| | | | 207 |
| | | | 205 |
| ETL | | | |
| REML | | | |
| AXL | GEML | BEML | EU2 |
| HTL | | | |
| pCGL | | | |
| nCGL | | | CGL 203 |
| ETL | | | |
| REML | GEML | BEML | EU1 |
| HTL | | | |
| HIL | | | |
| | | | 201 |

H1 H2 H3

PX1    PX2    PX3

## FIG. 21

# FIG. 22

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/209889 A1 (PARK CHANHYEOK [KR] ET AL) 29 June 2023 (2023-06-29) | 1,2,6, 10,11, 13,14 | INV. H10K59/80 |
| Y | * abstract * | 5,9 | |
| A | * paragraphs [0041] - [0057] *<br>* paragraph [0075] *<br>* figure 2 * | 4,7,8,12 | |
| X | WO 2023/130508 A1 (SHENZHEN CHINA STAR OPTOELECTRONICS SEMICONDUCTOR DISPLAY TECH CO LTD) 13 July 2023 (2023-07-13) | 1-3,6, 10,15 | |
| Y | * paragraph [0041] * | 5,9 | |
| A | * paragraphs [0061], [0068], [0078] *<br>* paragraph [0082] *<br>* figure 2 * | 4,7,8,12 | |
| X,P | -& US 2024/057460 A1 (WU JIEJIE [CN]) 15 February 2024 (2024-02-15) | 1-3,6, 10,15 | |
| Y,P | * paragraphs [0041], [0049] * | 5,9 | |
| A,P | * paragraphs [0052] - [0061] *<br>* paragraphs [0082] - [0085] *<br>* paragraph [0090] *<br>* figures 2,4 * | 4,7,8,12 | |
| | | | TECHNICAL FIELDS SEARCHED (IPC) |
| | | | H10K |
| Y | US 2021/144881 A1 (CHU SHANGCHIEH [CN] ET AL) 13 May 2021 (2021-05-13) | 5,9 | |
| A | * paragraph [0037] * | 4,7,8,12 | |

The present search report has been drawn up for all claims

| Place of search | Date of completion of the search | Examiner |
|---|---|---|
| Munich | 6 March 2025 | Pfattner, Raphael |

EPO FORM 1503 03.82 (P04C01)

## ANNEX TO THE EUROPEAN SEARCH REPORT
## ON EUROPEAN PATENT APPLICATION NO.

EP 24 20 9785

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2025

| Patent document cited in search report | | Publication date | Patent family member(s) | | Publication date |
|---|---|---|---|---|---|
| US 2023209889 | A1 | 29-06-2023 | CN | 116367601 A | 30-06-2023 |
| | | | KR | 20230099219 A | 04-07-2023 |
| | | | US | 2023209889 A1 | 29-06-2023 |
| WO 2023130508 | A1 | 13-07-2023 | CN | 114420865 A | 29-04-2022 |
| | | | US | 2024057460 A1 | 15-02-2024 |
| | | | WO | 2023130508 A1 | 13-07-2023 |
| US 2024057460 | A1 | 15-02-2024 | CN | 114420865 A | 29-04-2022 |
| | | | US | 2024057460 A1 | 15-02-2024 |
| | | | WO | 2023130508 A1 | 13-07-2023 |
| US 2021144881 | A1 | 13-05-2021 | CN | 115485755 A | 16-12-2022 |
| | | | US | 2021144881 A1 | 13-05-2021 |
| | | | WO | 2020177078 A1 | 10-09-2020 |

EPO FORM P0459

For more details about this annex : see Official Journal of the European Patent Office, No. 12/82